# EUROPEAN PATENT APPLICATION

(11) **EP 2 746 421 A1**
(43) Date of publication of application: **25.06.2014**
(21) Application number: 13779504.3
(22) Date of filing: 07.04.2013
(51) Int. Cl.: C22C 45/10

(54) **ZIRCONIUM-BASED AMORPHOUS ALLOY**

(30) Priority: 19.10.2012 CN 201210400725
(71) Applicant: Huawei Technologies Co., Ltd., Shenzhen, Guangdong 518129 (CN)
(72) Inventor: ZHANG, Tao, Shenzhen, Guangdong 518129 (CN); CHEN, Chen, Shenzhen, Guangdong 518129 (CN); YIN, Enhuai, Shenzhen, Guangdong 518129 (CN); FU, Liang, Shenzhen, Guangdong 518129 (CN); ZHU, Ailan, Shenzhen, Guangdong 518129 (CN)
(74) Representative: Körber, Martin Hans
(86) International application number: PCT/CN2013/073788
(87) International publication number: WO 2014/059769

(57) **Abstract**

A Zr-based amorphous alloy is provided; the formula of the Zr-based amorphous alloy is (Zr,Hf,Nb)ₐCu_{b}Ti_{c}Al_{d}Reₑ, where a, b, c, d, and e are corresponding atomic percent content of elements in the Zr-based amorphous alloy, 40 ≤ a ≤ 65, 20 ≤ b ≤ 50, 0.1 ≤ c < 10, 5 < d < 15, 0.05 ≤ e ≤ 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

## Description

### TECHNICAL FIELD

The present invention relates to the field of metal alloys, and in particular, to a Zr-based amorphous alloy.

### BACKGROUND

Due to a lack of a long-range order of an atomic arrangement of an amorphous alloy, neither dislocation nor grain boundary exists in the structure of the alloy. Therefore, compared with ordinary polycrystalline metal materials, amorphous alloys have merits such as high intensity, corrosion resistance, and abrasion resistance, and may be used as raw materials for manufacturing microelectronic devices, sports utilities, luxury goods, consumer electronics, and the like. A general method for manufacturing an amorphous alloy is to cool an alloy melt quickly to be below a glass transformation temperature (*T*_{g}) at a certain cooling speed. The extremely fast cooling speed avoids crystal nucleation and growth, and finally accomplishes a completely amorphous structure. If the cooling speed required for turning a material into an amorphous structure is lower, it is easier to form a large-sized amorphous structure of the material. In alloy systems such as Zr-based, palladium-based, magnesium-based, iron-based, copper-based, and lanthanum-based alloy systems, the critical cooling speed of specific alloys is less than 10 K/second in magnitude, and bulk amorphous alloys of a thickness of a centimeter magnitude may be manufactured through copper mold casting.

Generally, a critical diameter that can form a cast round bar of a completely amorphous structure is used as glass forming ability (GFA) of the alloy. The glass forming ability of the alloy primarily depends on chemical components of the alloy. Complexity and diversity of the alloy components can reduce the critical cooling speed of forming the amorphous structure and improve the glass forming ability of the alloy. Among them, a multi-element Zr-based amorphous alloy is an amorphous alloy that has ever been discovered so far having a good glass forming ability and superb mechanical and machining properties, and taking on the best application prospect of structural materials.

The Zr-based amorphous alloys that have been developed so far for forming an amorphous structure in the world centrally exist in the Zr-TM-Al or Zr-TM-Be (TM is Ti, Cu, Ni, or Co) system. With certain components of such alloys, a melt may cool down to form an amorphous round bar material of a diameter greater than 10 mm. Currently, the manufacturing of such alloys occurs primarily in labs. The oxygen content in an alloy is generally less than 200 ppm. Therefore, the oxygen content existent in the raw material and introduced in the manufacturing process must be controlled strictly.

For example, the following alloy formula can form an amorphous structure of a certain size after being cast:

(Zr,Hf)aMbAlc

where M is Ni, Cu, Fe, Co, or any combination thereof; a, b, and c are atomic percents, 25 ≤ a ≤ 85, 5 ≤ b ≤ 70, and 0 < c ≤ 35. Preferably, after vacuum melting and ordinary copper mold casting, the Zr50Cu40Al10 alloy can form a completely amorphous round bar of a 10 mm diameter, that is, have a glass forming ability of 10 mm.

To further enhance the glass forming ability of the alloy, a proper amount of Ni is generally added into the alloy, and combines with Cu into a specific formula. For example, after 5 at.% of Ni is added into the alloy, a four-element Zr55Cu30Ni5Al10 alloy is obtained, whose glass forming ability is up to 30 mm. A general manufacturing method is as follows: Place a specific quantity of raw materials of a specific formula into a vacuum smelting furnace, adjust the vacuum degree to 5 x 10⁻³ Pa, and then charge with 0.05 MPa argon as protection gas; after homogeneous smelting and cooling with the furnace, obtain a master alloy; subsequently, place the master alloy into an induction furnace for re-melting, and then spray and cast the master alloy into a copper mold to obtain amorphous alloy bars.

The GFA of a Zr-based alloy in the prior art is very sensitive to oxygen content of the alloy. Because cohesion of Zirconium and oxygen occurs very easily, zirconium oxide or zirconium/oxygen clusters can be generated easily in the alloy melt. They may serve as a core of non-homogeneous nucleation, and reduce the GFA of the alloy. Under ordinary laboratory or industrial conditions, a certain amount of oxygen is inevitably introduced into the Zr-based amorphous alloy. Therefore, expensive high-purity raw materials have to be used in the production process, and a high vacuum degree is required in smelting and casting processes. The required vacuum degree is over 10⁻² Pa or even 10⁻³ Pa to prevent decrease of the amorphous GFA caused by high oxygen content in the alloy. High-purity (a purity of over 99.9%) raw materials and stringent protection atmosphere lead to very high costs of manufacturing a Zr-based amorphous alloy, and make mass production impracticable. Ordinary industrial raw materials in the market are not good enough for manufacturing components and products of an amorphous structure of specific dimensions.

### SUMMARY

Embodiments of the present invention provide a Zr-based amorphous alloy that ensures the capability of forming an amorphous bulk on the basis of lower process requirements such as a lower material purity and a lower casting environment vacuum degree.

An embodiment of the present invention provides a Zr-based amorphous alloy, where the Zr-based amorphous alloy has the following formula:

(Zr,Hf,Nb)ₐCu_{b}Ti_{c}Al_{d}Reₑ,

where a, b, c, d, and e are corresponding atomic percent content of elements in the Zr-based amorphous alloy, 40 ≤ a ≤ 65, 20 ≤ b ≤ 50, 0.1 ≤ c ≤ 10,5 ≤ d ≤ 15, 0.05 ≤ e ≤ 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

A method for manufacturing a Zr-based amorphous alloy, including: melting metal raw materials completely under a protection atmosphere or vacuum condition, and then performing casting, cooling, and molding to form a Zr-based amorphous alloy, where the Zr-based amorphous alloy has the following formula:

(Zr,Hf,Nb)ₐCu_{b}Ti_{c}Al_{d}Reₑ,

where a, b, c, d, and e are corresponding atomic percent content of elements in the Zr-based amorphous alloy, 40 ≤ a ≤ 65, 20 ≤ b ≤ 50, 0.1 ≤ c ≤ 10, 5 ≤ d ≤ 15, 0.05 ≤ e ≤ 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

An electronic device, including a casing and electronic components placed in the casing, where the casing is made of a Zr-based amorphous alloy, and the Zr-based amorphous alloy has the following formula:

(Zr,Hf,Nb)ₐCu_{b}TicAl_{d}Reₑ,

where a, b, c, d, and e are corresponding atomic percent content of elements in the Zr-based amorphous alloy, 40 ≤ a ≤ 65, 20 ≤ b ≤ 50, 0.1 ≤ c ≤ 10, 5 ≤ d ≤ 15, 0.05 ≤ e ≤ 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

In the embodiments of the present invention, trace quantities of rare earth elements (0.05-5 atomic percent) are added into an alloy to suppress a crystallization trend and improve melt stability; the rare earth elements can absorb oxygen in the alloy, adjust oxygen content of the alloy, suppress heterogeneous nucleation, avoid crystallization of liquid metal in a cooling process, enhance glass forming ability of the alloy, thereby widening the choice range of raw materials required for manufacturing an amorphous alloy. Moreover, a product of a high glass forming ability can be manufactured without using high-purity raw materials, and we can further reduce process requirements such as vacuum degree, which slashes production costs.

### BRIEF DESCRIPTION OF DRAWINGS

To illustrate the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is an XRD diffraction analysis result diagram of a Zr-based amorphous alloy of two components according to an embodiment of the present invention; and
FIG. 2 is a schematic diagram of an electronic device according to Embodiment 8 of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

The present invention provides an easily formable Zr-based amorphous alloy, where the Zr-based amorphous alloy of an amorphous structure may be subjected to an ordinary copper mold casting method or a conventional parts casting method to generate amorphous bulk materials or parts of an amorphous structure. The Zr-based amorphous alloy includes Zr, Ti, Cu, Al, and one or more elements of rare earth, in which Zr may be partly replaced with Hf, and Cu may be partly or completely replaced with Ni. An atomic percent of each element in the final amorphous alloy fulfills the following general formula:

(Zr,Hf,Nb)ₐCubTi_{c}AlReₑ,

where a, b, c, d, and e are corresponding atomic percent content of elements in the amorphousalloy,40 ≤ a ≤ 65, 20 ≤ b ≤ 50, 0.1 ≤ c ≤ 10,5 ≤ d ≤ 15, 0.05 ≤ e ≤ 5, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal, expressed by MM in the molecular formula). In some embodiments, the Re is preferably one or a combination of plural ones selected from a group of elements La, Nd, Dy, Er, Tm, and Yb.

For example, in some embodiments, the Zr-based amorphous alloy may include the following components: Zr48.7Hf1Ti2Cu37.8Al10Er0.5, Zr48.7Hf1Ti2Cu37.8Al10(YEr)0.5, Zr48.7Hf1Ti2Cu37.81Al10(Y,MM)0.5, Zr59Ti2Cu251Al12Er2, Zr57 Ti2Cu301Al10La1, Zr57Ti1Cu311Al9Gd2, Zr58Cu25Al12Ti2Hf1Er2, Zr59Cu25Al12Ti1Nb1Er2, Zr59.5Hf1Ti2Cu251Al12Er0.5, and the like.

With the Zr-based amorphous alloy in the foregoing range of components, an alloy ingot of a bar shape, granule shape, or strip shape may be obtained first through arc melting or induction melting by using low-purity raw materials at a low vacuum degree (lower than 1 x 10⁻³ Pa), and then the alloy ingot is re-melted or cast at a low vacuum degree (lower than 1 x 10⁻² Pa) to obtain an amorphous bar or amorphous part of a relatively large size.

The present invention provides a method for manufacturing a Zr-based amorphous alloy of the foregoing molecular formula. The method includes: preparing components in the foregoing (Zr,Hf,Nb)ₐCu_{b}Ti_{c}Al_{d}Reₑ Zr-based amorphous alloy according to a molecular ratio within a range of a, b, c, d, and e in the alloy, where 40 ≤ a ≤ 65, 20 ≤ b ≤ 50, 0.1 ≤ c ≤ 10, 5 ≤ d ≤ 15, 0.05 ≤ e ≤ 5, and a + b + c + d + e ≤ 100; melting such components into a master alloy until they are fully blended homogeneously; and performing casting and cooling for the master alloy to obtain an amorphous bar formed of the Zr-based amorphous alloy. The casting may be pouring, suction casting, or spray casting. For example, the Zr-based amorphous alloy in the present invention may have any one of the components listed in Table 1:

**Table 1**

| **Serial Number** | **Alloy Component** |
|---|---|
| 1 | Zr48.7Hf1Ti2Cu37.8Al10(Y,Er)0.5 |
| 2 | Zr49.7Ti2Cu38.1Al10Er0.1Y0.1 |
| 3 | Zr50Hf8Ti2Cu25Al10La5 |
| 4 | Zr50Hf1Ti2Cu351Al9Ce3 |
| 5 | Zr48.7Hf1Ti2Cu37.8Al10Re0.5 |
| 6 | Zr62.8Ti0.2Cu20Al15Er2 |
| 7 | Zr40 Ti10Cu39Al10La1 |
| 8 | Zr57 Ti1Cu31Al9Gd2 |
| 9 | Zr48.7Hf0.6Cu38.45Ti2Al10Er0.25 |
| 10 | Zr60.5Ti2Cu25Al12Er0.5 |
| 11 | Zr60.5Hf0.8Ti1.2Cu25Al12Er0.5 |
| 12 | Zr59Cu25Al12Ti1Nb1Er2 |
| 13 | Zr59.5Hf1Ti2Cu25Al12Er0.5 |
| 14 | Zr62.85Cu22Al15Ti0.1Er0.05 |
| 15 | Zr40Cu42.9Al15Ti0.1Er2 |
| 16 | Zr65Cu20Al12.9Ti0.1Er2 |
| 17 | Zr40Cu50Al9.8Ti0.1Re0.1 |
| 18 | Zr40Cu30Al15Ti10La5 |
| 19 | Zr55Cu20Al10Ti10Ce5 |
| 20 | Zr40Cu40Al8Ti10Er2 |
| 21 | Zr55Ti10Cu25Al5Er5 |
| 22 | Zr40Cu40Al5Ti10Nd5 |
| 23 | Zr60Cu25Al10Ti0.1Hf2.9Er2 |
| 24 | Zr61Cu25Al10Ti0.1Nb1.9Sc2 |
| 25 | Zr57.9Cu25Ni5Al10Ti0.1Sc2 |
| 26 | Zr49Cu38Al10Ti2Er1 |
| 27 | Zr60Ti2Cu25Al12Dy1 |
| 28 | Zr49.7Cu37.8Al10Ti2Tm0.5 |
| 29 | Zr50Cu37Al10Ti2Yb1 |
| 30 | Zr60.5Ti2Cu25Al12Tm0.5 |
| 31 | Zr60.5Ti1.5Cu25Al12Yb1 |
| 32 | Zr60.5Hf0.8Ti1.2Cu25Al12Nd0.5 |
| 33 | Zr49Hf1Cu37Al10Ti2Tm1 |
| 34 | Zr59 Nb1Cu25Al12Ti2Tm1 |
| 35 | Zr59 Nb1Cu25Al12Ti1Yb2 |
| 36 | Zr49Ti2Cu36Ni2Al10Er1 |
| 37 | Zr49.5Ti2Cu36Ni2Al10Tm0.5 |
| 38 | Zr60Ti2Cu24Ni1Al12Er1 |
| 39 | Zr49Ti2Cu36Ni2Al10Dy1 |
| 40 | Zr60.5Ti2Cu24Ni1Al12Nd0.5 |
| 41 | Zr59.5Ti2Cu25Al12Er0.5Tm0.5Y0.5 |
| 42 | Zr50Ti1Cu36Ni2.5Al10Yb0.5 |

The method for manufacturing a Zr-based amorphous alloy may include the following steps:

### Step 1: Components preparation

Components are prepared within the range of the formula at a specific atomic percent. For example, components are prepared according to each component and a specific atomic percent in Table 1.

In the preparation process, components of the alloy may be prepared according to the components and atomic percents in Table 1 by using materials such as metal rods, blocks, ingots and plates made of elements Zr, Hf, Ti, Cu, Al, Er, and the like, with a purity of 99.5%.

### Step 2: Melting

The prepared raw materials are melted under a protection atmosphere or vacuum condition to achieve homogeneous fusion of all components.

The melting method is not limited. Any melting method is appropriate so long as metals of various components are thoroughly melted and fused. A melting device may also be any type of conventional melting device. In the embodiments of the present invention, the melting equipment is preferably an arc melting furnace or an induction melting furnace. That is, the prepared raw materials are placed into an arc furnace water-cooled copper crucible or an induction melting crucible and vacuum-pumped to 6-9 x 10⁻¹ Pa, and charged with argon of from 0.03 to 0.08 MPa as protection gas. Heating is applied until the materials are melted to form an alloy material whose components are completely homogeneous. The vacuum degree is preferably 8 x 10⁻¹ Pa, and the argon protection gas is preferably of 0.05 MPa.

### Step 3: Casting and cooling to form an amorphous alloy

The melted alloy material is cast into a mold to cool down, so as to obtain the Zr-based amorphous alloy of the foregoing molecular formula according to the corresponding components.

The detailed steps may be as follows: Place a specific amount of prepared master alloy into a high-frequency induction furnace graphite crucible; create a vacuum below 0.1 Pa, and charge argon of 0.05 MPa into the vacuum; heat the graphite crucible until the temperature is higher than the melting point of the alloy material so that the alloy material is completely melted down; turn over the graphite crucible and pour the melt into a copper mold to form amorphous rods; or, by using a die-casting method, lead the alloy into a feeding pool of a die-casting device, and use a die-casting mold to form parts of complex dimensions.

The cooling speed of the cooling processing is 1-10 x 10K/second, so as to suppress crystallization and form a cylinder-shaped fully amorphous alloy of a 10 mm critical size.

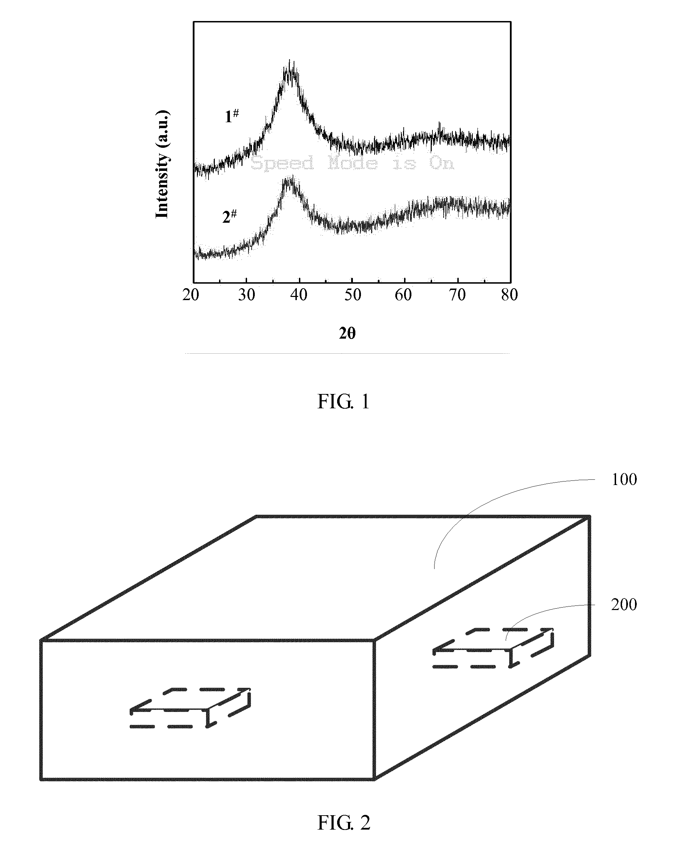

FIG. 1 is an X ray diffraction (XRD) analysis result diagram of two formulas sampled randomly in the table. The XRD spectrum is a typical amorphous diffuse peak, without a diffraction peak of a crystal phase, indicating that the entire cast bar is a single amorphous phase. In the figure, 1^{#} and 2^{#} represent two sampled formulas Zr49Cu38Al10Ti2Er1 (1^{#}) and Zr49.7Ti2Cu38.1Al10Er0.1Y0.1 (2^{#}), where the X coordinate represents an XRD diffraction angle (2θ), and the Y coordinate represents relative diffraction intensity.

In the embodiments of the present invention, trace quantities of rare earth elements (0.05-5 atomic percent) are added into an alloy to suppress a crystallization trend and improve melt stability; the rare earth elements can absorb oxygen in the alloy, adjust oxygen content of the alloy, suppress heterogeneous nucleation, avoid crystallization of liquid metal in a cooling process, enhance glass forming ability of the alloy, thereby widening the choice range of raw materials required for manufacturing an amorphous alloy. Moreover, a product of a high glass forming ability can be manufactured without using high-purity raw materials, and we can further reduce process requirements such as vacuum degree, which slashes production costs.

### Embodiment 1

Embodiment 1 of the present invention provides a Zr-based amorphous alloy, whose components and atomic percents fulfill the following general formula:

ZrₐCu_{b}Ti_{c}Al_{d}Reₑ,

where a, b, c, d, and e are corresponding atomic percent content of elements in the amorphous alloy, 56 ≤ a ≤ 63, 22 ≤ b ≤ 35, 0.1 ≤ c ≤ 4,7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, Re is preferably one or a combination of plural ones selected from a group of Gd, Er, and Dy. For example, the Zr-based amorphous alloy expressed by the general formula specifically includes Zr57Ti1Cu31Al9Gd2, Zr62.8Ti0.2Cu20Al15Er2, Zr60.5Ti2Cu25Al12Er0.5, Zr62.85Cu22Al15Ti0.1Er0.05, Zr62.8Ti0.2Cu20Al15Er2, Zr60Ti2Cu25Al12Dy1, and the like.

### Embodiment 2

Embodiment 2 of the present invention provides a Zr-based amorphous alloy, whose components and atomic percents fulfill the following general formula:

ZrₐCu_{b}Ti_{c}Al_{d}Reₑ,

where a, b, c, d, and e are corresponding atomic percent content of elements in the amorphous alloy, 46 ≤ a ≤ 52, 36 ≤ b ≤ 42, 0.1 ≤ c ≤ 4,7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, preferably, Re is Er and Y, or is one or a combination of plural ones selected from a group of Er, Tm, and Yb. For example, the Zr-based amorphous alloy expressed by the general formula specifically includes Zr49Cu38Al10Ti2Er1, Zr49.7Ti2Cu38.1Al10Er0.1Y0.1, Zr49.7Cu37.8Al10Ti2Tm0.5, Zr50Cu37Al10Ti2Yb1, and the like.

### Embodiment 3

Embodiment 3 of the present invention provides a Zr-based amorphous alloy, whose components and atomic percents fulfill the following general formula:

(Zr,Hf)ₐCu_{b}Ti_{c}Al_{d}Reₑ,

where a, b, c, d, and e are corresponding atomic percent content of elements in the amorphous alloy, 58 ≤ a ≤ 65, 22 ≤ b ≤ 35, 0.1 ≤ c ≤ 4, 7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, Re is preferably one or a combination of plural ones selected from a group of Er, Yb, Nd, and Tm; the percent content of Hf in (Zr, Hf) is from 0 to 8. For example, the Zr-based amorphous alloy expressed by the general formula specifically includes Zr59.5Ti2Cu25Al12Er0.5Tm0.5Y0.5, Zr60.5Ti2Cu25Al12Er0.5, Zr60.5Ti2Cu25Al12Tm0.5, Zr60.5Hf0.8Ti1.2Cu25Al12Er0.5, Zr59.5Hf1Ti2Cu25Al12Er0.5, Zr62.85Cu22Al15Ti0.1Er0.05, Zr60.5Ti1.5Cu25Al12Yb1, Zr60.5Hf0.8Ti1.2Cu25Al12Nd0.5, Zr65Cu20Al12.9Ti0.1Er2, Zr60 Hf2.9Cu25Al10Ti0.1Er2, and the like.

### Embodiment 4

Embodiment 4 of the present invention provides a Zr-based amorphous alloy, whose components and atomic percents fulfill the following general formula:

(Zr,Hf)ₐCu_{b}Ti_{c}Al_{d}Reₑ,

where a, b, c, d, and e are corresponding atomic percent content of elements in the amorphous alloy, 48 ≤ a ≤ 54, 36 ≤ b ≤ 42, 0.1 ≤ c ≤ 4, 7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, preferably, Re is Er and Y, or is one or a combination of plural ones selected from a group of Er, La, Tm, and Ce; the percent content of Hf in (Zr, Hf) is from 0 to 8. For example, the Zr-based amorphous alloy expressed by the general formula specifically includes Zr49Cu38Al10Ti2Er1, Zr48.7Hf1Ti2Cu37.8Al10(Y,Er)0.5, Zr49.7Ti2Cu38.1Al10Er0.1Y0.1, Zr50Hf1Ti2Cu351Al9Ce3, Zr48.7Hf0.6Cu38.45Ti2Al10Er0.25, Zr49Hf1Cu37Al10Ti2Tml, and the like.

### Embodiment 5

Embodiment 5 of the present invention provides a Zr-based amorphous alloy, whose components and atomic percents fulfill the following general formula:

(Zr,Nb)ₐCu_{b}Ti_{c}Al_{d}Reₑ,

where a, b, c, d, and e are corresponding atomic percent content of elements in the amorphous alloy, 58 ≤ a ≤ 65, 22 ≤ b ≤ 35, 0.1 ≤ c ≤ 4, 7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, Re is preferably one or a combination of plural ones selected from a group of Er, Tm, and Yb; the percent content of Nb in (Zr, Nb) is from 0 to 2. For example, the Zr-based amorphous alloy expressed by the general formula specifically includes Zr59Nb1Cu25Al12Ti1Er2, Zr60.5Ti2Cu25Al12Er0.5, Zr62.85Cu22Al15Ti0.1Er0.05, Zr65Cu20Al12.9Ti0.1Er2, Zr59Nb1Cu25Al12Ti2Tm1, Zr59Nb1Cu25Al12Ti1Yb2, and the like.

### Embodiment 6

Embodiment 6 of the present invention provides a Zr-based amorphous alloy, whose components and atomic percents fulfill the following general formula:

(Zr,Nb)ₐCu_{b}Ti_{c}Al_{d}Reₑ,

where a, b, c, d, and e are corresponding atomic percent content of elements in the amorphous alloy, 48 ≤ a ≤ 54, 36 ≤ b ≤ 42, 0.1 ≤ c ≤ 4, 7 ≤ d ≤ 13, 0.05 ≤ e ≤ 2, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, preferably, Re is Er and Y, or is Er and/or Ce; and the percent content of Nb in (Zr, Nb) is from 0 to 2.

### Embodiment 7

Embodiment 7 of the present invention provides a Zr-based amorphous alloy. In components of the Zr-based amorphous alloy in this embodiment, a part of Cu is replaced with Ni, that is, the Zr-based amorphous alloy has the following formula:

Zrₐ(Cu,Ni)_{b}Ti_{c}Al_{d}Reₑ,

where a, b, c, d, and e are atomic percent content of elements in the amorphous alloy, and fulfill 46 ≤ a ≤ 50, 36 ≤ b ≤ 42, 0.1 ≤ c ≤ 5, 7 ≤ d ≤ 13, and 0.05 ≤ e ≤ 2 respectively;
or
where a, b, c, d, and e are atomic percent content of elements in the amorphous alloy, and fulfill 54 ≤ a ≤ 63, 22 ≤ b ≤ 35, 0.1 ≤ c ≤ 5, 7 ≤ d ≤ 13, and 0.05 ≤ e ≤ 2 respectively.

Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu; or Re is combined of Y and one or a combination of plural ones selected from a group of elements La, Ce, Po, Ho, Er, Nd, Gd, Dy, Sc, Eu, Tm, Tb, Pr, Sm, Yb, and Lu. The Re element group may be obtained by adding mishch metal (Misch Metal).

Component preparation, melting, casting and cooling are performed according to the general formula and the method for manufacturing a Zr-based amorphous alloy, so as to form a Zr-based amorphous alloy expressed by the general formula.

In this embodiment, Re is preferably one or a combination of plural ones selected from a group of Er, Sc, Tm, Dy, Nd, and Yb; and the percent content of Ni in (Cu, Ni) is from 0 to 15. For example, the Zr-based amorphous alloy expressed by the general formula specifically includes Zr57.9Cu25N15Al10Ti0.1Sc2, Zr62.85Cu22Al15Ti0.1Er0.05, Zr49Ti2Cu36Ni2Al10Er1, Zr49.5Ti2Cu36Ni2Al10Tm0.5, Zr60Ti2Cu24Ni1Al12Er1, Zr49Ti2Cu36Ni2Al10Dy1, Zr60.5Ti2Cu24Ni1Al12Nd0.5, Zr50Ti1Cu36Ni2.5Al10Yb0.5, and the like.

### Embodiment 8

As shown in FIG. 2, Embodiment 9 of the present invention provides an electronic device, where the electronic device includes a casing 100 and electronic components 200 placed in the casing. The casing 100 is made of the foregoing Zr-based amorphous alloy. For example, the Zr-based amorphous alloy that makes up the casing 100 includes Zr, Ti, Cu, Al, and one or more elements of rare earth, in which Zr may be partly replaced with Hf, and Cu may be partly or completely replaced with Ni. An atomic percent of each element in the final amorphous alloy fulfills the following general formula:

(Zr,Hf,Nb)ₐCu_{b}Ti_{c}Al_{d}Reₑ,

where a, b, c, d, and e are corresponding atomic percent content of elements in the amorphous alloy, 40 ≤ a ≤ 65, 20 ≤ b ≤ 50, 0.1 ≤ c ≤ 10, 5 ≤ d ≤ 15, 0.05 ≤ e ≤ 5, a + b + c + d + e ≤ 100, Re is one or more elements of rare earth, that is, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu. In some embodiments, the Re is preferably one or a combination of plural ones selected from a group of elements La, Nd, Dy, Er, Tm, and Yb. The Re element group may be obtained by adding mishch metal (Misch Metal).

The casing 100 may be made of the Zr-based amorphous alloy described in any one of Embodiments 1 to 8.

The casing 100 made of the Zr-based amorphous alloy provides high mechanical performance, such as high rigidity, high intensity, and high resilience, and has merits such as low difficulty of making the Zr-based amorphous alloy and relatively low costs.

It should be noted that the components described in the embodiments of the present invention do not involve non-metal components such as oxygen and nitrogen, but those skilled in the art know that a certain content of non-metal elements such as oxygen and nitrogen is inevitable in an alloy. For example, in the process of melting a Zr-based amorphous alloy in the embodiment of the present invention, oxidation may occur and introduce certain oxygen content, which is inevitable in the current manufacturing process. Therefore, amorphous alloys of homogeneous metal components combined with certain non-metal components shall fall within the protection scope of the present invention.

Finally, the foregoing embodiments are merely intended for describing the technical solutions of the embodiments of the present invention rather than limiting the present invention. Although the embodiments of the present invention are described in detail with reference to preferred embodiments, persons of ordinary skill in the art should understand that they may still make modifications to the technical solutions described in the embodiments of the present invention or make equivalent replacements to some technical features thereof, without departing from the spirit and scope of the technical solutions of the embodiments of the present invention.

## Claims

1. A Zr-based amorphous alloy, wherein the Zr-based amorphous alloy has the following formula:
(Zr,Hf,Nb)ₐCu_{b}Ti_{c}Al_{d}Reₑ,
wherein a, b, c, d, and e are corresponding atomic percent content of elements in the Zr-based amorphous alloy, 40 ≤ a ≤ 65, 20 ≤ b ≤ 50, 0.1 ≤ c ≤ 10, 5 ≤ d ≤ 15, 0.05 ≤ e ≤ 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

2. The Zr-based amorphous alloy according to claim 1, wherein the Re is one or a combination of plural ones selected from a group of elements La, Ce, Gd, Nd, Dy, Er, Tm, and Yb.

3. The Zr-based amorphous alloy according to claim 1 or 2, wherein the Zr-based amorphous alloy has the following formula:
ZrₐCu_{b}Ti_{c}Al_{d}Reₑ,
wherein a, b, c, d, and e are atomic percent content of elements in the amorphous alloy, and fulfill 56 ≤ a ≤ 63, 22 ≤ b ≤ 35, 0.1 ≤ c ≤ 4, 7 ≤ d ≤ 13, and 0.05 ≤ e ≤ 2 respectively.

4. The Zr-based amorphous alloy according to claim 3, wherein the Re is one or a combination of plural ones selected from a group of Gd, Er, and Dy.

5. The Zr-based amorphous alloy according to claim 4, wherein the Zr-based amorphous alloy has one of the following formulas: Zr57Ti1Cu31Al9Gd2, Zr62.8Ti0.2Cu20Al15Er2, Zr60.5Ti2Cu25Al12Er0.5, Zr60Ti2Cu25Al12Dy1, Zr62.85Cu22Al15Ti0.1Er0.05, and Zr62.8Ti0.2Cu20Al15Er2.

6. The Zr-based amorphous alloy according to claim 1 or 2, wherein the Zr-based amorphous alloy has the following formula:
ZrₐCu_{b}Ti_{c}Al_{d}Reₑ,
wherein a, b, c, d, and e are atomic percent content of elements in the amorphous alloy, and fulfill 46 ≤ a ≤ 52, 36 ≤ b ≤ 42, 0.1 ≤ c ≤ 4, 7 ≤ d ≤ 13, and 0.05 ≤ e ≤ 2 respectively.

7. The Zr-based amorphous alloy according to claim 6, wherein the Re is Er and Y, or is one or a combination of plural ones selected from a group of Er, Tm, and Yb.

8. The Zr-based amorphous alloy according to claim 1, wherein the Zr-based amorphous alloy has one of the following formulas: Zr49Cu38Al10Ti2Er1, Zr49.7Ti2Cu38.1Al10Er0.1Y0.1, Zr49.7Cu37.8Al10Ti2Tm0.5, and Zr50Cu37Al10Ti2Yb1.

9. The Zr-based amorphous alloy according to claim 1 or 2, wherein the Zr-based amorphous alloy has the following formula:
(Zr,Hf)ₐCu_{b}Ti_{c}Al_{d}Reₑ,
wherein a, b, c, d, and e are atomic percent content of elements in the amorphous alloy, and fulfill 58 ≤ a ≤ 65, 22 ≤ b ≤ 35, 0.1 ≤ c ≤ 4, 7 ≤ d ≤ 13, and 0.05 ≤ e ≤ 2 respectively.

10. The Zr-based amorphous alloy according to claim 9, wherein percent content of the Hf is from 0 to 8.

11. The Zr-based amorphous alloy according to claim 10, wherein the Re is Er and/or Tm and Y, or is one or a combination of plural ones selected from a group of Er, Yb, Nd, and Tm.

12. The Zr-based amorphous alloy according to claim 11, wherein the Zr-based amorphous alloy has one of the following formulas: Zr59.5Ti2Cu25Al12Er0.5Tm0.5Y0.5, Zr60.5Ti2Cu25Al12Er0.5, Zr60.5Ti2Cu25Al12Tm0.5, Zr60.5Hf0.8Ti1.2Cu25Al12Er0.5, Zr59.5Hf1Ti2Cu25Al12Er0.5, Zr62.85Cu22Al15Ti0.1Er0.05, Zr60.5Ti1.5Cu25Al12Yb1, Zr60.5Hf0.8Ti1.2Cu25Al12Nd0.5, Zr65Cu20Al12.9Ti0.1Er2, and Zr60 Hf2.9Cu25Al10Ti0.1Er2.

13. The Zr-based amorphous alloy according to claim 1 or 2, wherein the Zr-based amorphous alloy has the following formula:
(Zr,Hf)ₐCu_{b}Ti_{c}Al_{d}Reₑ,
wherein a, b, c, d, and e are atomic percent content of elements in the amorphous alloy, and fulfill 48 ≤ a ≤ 54, 36 ≤ b ≤ 42, 0.1 ≤ c ≤ 4, 7 ≤ d ≤ 13, and 0.05 ≤ e ≤ 2 respectively.

14. The Zr-based amorphous alloy according to claim 13, wherein the Re is Er and Y, or is one or a combination of plural ones selected from a group of Er, La, Ce, and Tm.

15. The Zr-based amorphous alloy according to claim 14, wherein percent content of the Hf is from 0 to 8.

16. The Zr-based amorphous alloy according to claim 15, wherein the Zr-based amorphous alloy has one of the following formulas: Zr49Cu38Al10Ti2Er1, Zr48.7Hf1Ti2Cu37.8Al10(Y,Er)0.5, Zr49.7Ti2Cu38.1Al10Er0.1Y0.1, Zr50Hf1Ti2Cu351Al9Ce3, Zr48.7Hf0.6Cu38.45Ti2Al10Er0.25, and Zr49Hf1Cu37Al10Ti2Tm1.

17. The Zr-based amorphous alloy according to claim 1 or 2, wherein the Zr-based amorphous alloy has the following formula:
(Zr,Nb)ₐCu_{b}Ti_{c}Al_{d}Reₑ,
wherein a, b, c, d, and e are atomic percent content of elements in the amorphous alloy, and fulfill 58 ≤ a ≤ 65, 22 ≤ b ≤ 35, 0.1 ≤ c ≤ 4, 7 ≤ d ≤ 13, and 0.05 ≤ e ≤ 2 respectively.

18. The Zr-based amorphous alloy according to claim 17, wherein percent content of the Nb is from 0 to 2.

19. The Zr-based amorphous alloy according to claim 18, wherein the Re is one or a combination of plural ones selected from a group of Er, Tm, and Yb.

20. The Zr-based amorphous alloy according to claim 19, wherein the Zr-based amorphous alloy has one of the following formulas: Zr59Nb1Cu25Al12Ti1Er2, Zr60.5Ti2Cu25Al12Er0.5, Zr62.85Cu22Al15Ti0.1Er0.05, Zr65Cu20Al12.9Ti0.1Er2, Zr59 Nb1Cu25Al12Ti2Tm1, and Zr59 Nb1Cu25Al12Ti1Yb2.

21. The Zr-based amorphous alloy according to claim 1 or 2, wherein the Zr-based amorphous alloy has the following formula:
(Zr,Nb)ₐCu_{b}Ti_{c}Al_{d}Reₑ,
wherein a, b, c, d, and e are atomic percent content of elements in the amorphous alloy, and fulfill 48 ≤ a ≤ 54, 36 ≤ b ≤ 42, 0.1 ≤ c ≤ 4, 7 ≤ d ≤ 13, and 0.05 ≤ e ≤ 2 respectively.

22. The Zr-based amorphous alloy according to claim 21, wherein the Re is Er and Y, or is one or a combination of plural ones selected from a group of Er, Tm, Dy, Nd, and Yb.

23. The Zr-based amorphous alloy according to claim 1 or 2, wherein in the components of the Zr-based amorphous alloy, a part of Cu is replaced with Ni, that is, the Zr-based amorphous alloy has the following formula:
Zrₐ(Cu,Ni)_{b}Ti_{c}Al_{d}Reₑ,
wherein a, b, c, d, and e are atomic percent content of elements in the amorphous alloy, and fulfill 46 ≤ a ≤ 50, 36 ≤ b ≤ 42, 0.1 ≤ c ≤ 5, 7 ≤ d ≤ 13, and 0.05 ≤ e ≤ 2 respectively.

24. The Zr-based amorphous alloy according to claim 1 or 2, wherein in the components of the Zr-based amorphous alloy, a part of Cu is replaced with Ni, that is, the Zr-based amorphous alloy has the following formula:
Zrₐ(Cu,Ni)_{b}Ti_{c}Al_{d}Reₑ,
wherein a, b, c, d, and e are atomic percent content of elements in the amorphous alloy, and fulfill 54 ≤ a ≤ 63, 22 ≤ b ≤ 35, 0.1 ≤ c ≤ 5, 7 ≤ d ≤ 13, and 0.05 ≤ e ≤ 2 respectively.

25. The Zr-based amorphous alloy according to claim 23 or 24, wherein the Re is one or a combination of plural ones selected from a group of Er, Sc, Tm, Dy, Nd, and Yb.

26. The Zr-based amorphous alloy according to claim 25, wherein percent content of the Ni is from 0 to 15.

27. The Zr-based amorphous alloy according to claim 25, wherein the Zr-based amorphous alloy has one of the following formulas: Zr57.9Cu25Ni5Al10Ti0.1Sc2, Zr62.85Cu22Al15Ti0.1Er0.05, Zr49Ti2Cu36Ni2Al10Er1, Zr49.5Ti2Cu36Ni2Al10Tm0.5, Zr60Ti2Cu24Ni1Al12Er1, Zr49Ti2Cu36Ni2Al10Dy1, Zr60.5Ti2Cu24Ni1Al12Nd0.5, and Zr50Ti1Cu36Ni2.5Al10Yb0.5.

28. The Zr-based amorphous alloy according to claim 1 or 2, wherein the Zr-based amorphous alloy has one of the following formulas: Zr48.7Hf1Ti2Cu37.81Al10Er0.5, Zr48.7Hf1Ti2Cu37.81A110(Y,Er)0.5, Zr59Ti2Cu251Al12Er2, Zr57Ti2Cu301Al10La1, Zr57Ti1Cu311Al9Gd2, Zr58Cu25Al12Ti2Hf1Er2, Zr59Cu25Al12Ti1Nb1Er2, and Zr59.5Hf1Ti2Cu251Al12Er0.5.

29. A method for manufacturing a Zr-based amorphous alloy, comprising: melting metal raw materials completely under a protection atmosphere or vacuum condition, and then performing casting, cooling, and molding to form a Zr-based amorphous alloy, wherein the Zr-based amorphous alloy has the following formula:
(Zr,Hf,Nb)ₐCu_{b}Ti_{c}Al_{d}Reₑ,
wherein a, b, c, d, and e are corresponding atomic percent content of elements in the Zr-based amorphous alloy, 40 ≤ a ≤ 65, 20 ≤ b ≤ 50, 0.1 ≤ c < 10, 5 < d < 15, 0.05 < e < 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

30. The manufacturing method according to claim 29, wherein the Re is one or a combination of plural ones selected from a group of elements La, Nd, Dy, Er, Tm, and Yb.

31. The manufacturing method according to claim 29, wherein in the melting process, a vacuum degree is 8×10⁻¹ Pa, and a charged argon protection gas is of 0.05 MPa.

32. An electronic device, comprising a casing and electronic components placed in the casing, wherein the casing is made of a Zr-based amorphous alloy, and the Zr-based amorphous alloy has the following formula:
(Zr,Hf,Nb)ₐCu_{b}TicAl_{d}Reₑ,
wherein a, b, c, d, and e are corresponding atomic percent content of elements in the Zr-based amorphous alloy, 40 ≤ a ≤ 65, 20 ≤ b ≤ 50, 0.1 ≤ c < 10, 5 < d < 15, 0.05 < e < 5, a + b + c + d + e ≤ 100, Re is one or a combination of plural ones selected from a group of elements La, Ce, Po, Ho, Er, Nd, Gd, Dy, Sc, Eu, Tm, Tb, Pr, Sm, Yb, and Lu, or Re is combined of Y and one or a combination of plural ones selected from a group of elements La, Ce, Po, Ho, Er, Nd, Gd, Dy, Sc, Eu, Tm, Tb, Pr, Sm, Yb, and Lu.

33. The electronic device according to claim 32, wherein the Re is one or a combination of plural ones selected from a group of elements La, Nd, Dy, Er, Tm, and Yb.

34. The electronic device according to claim 32 or 33, wherein the Zr-based amorphous alloy has the following formula:
ZrₐCu_{b}Ti_{c}Al_{d}Reₑ,
wherein a, b, c, d, and e are atomic percent content of elements in the amorphous alloy, and fulfill 56 ≤ a ≤ 63, 22 ≤ b ≤ 35, 0.1 ≤ c ≤ 4, 7 ≤ d ≤ 13, and 0.05 ≤ e ≤ 2 respectively.

35. The electronic device according to claim 32 or 33, wherein the Zr-based amorphous alloy has the following formula:
ZrₐCu_{b}Ti_{c}Al_{d}Reₑ,
wherein a, b, c, d, and e are atomic percent content of elements in the amorphous alloy, and fulfill 46 ≤ a ≤ 52, 36 ≤ b ≤ 42, 0.1 ≤ c ≤ 4, 7 ≤ d ≤ 13, and 0.05 ≤ e ≤ 2 respectively.

36. The electronic device according to claim 32 or 33, wherein the Zr-based amorphous alloy has the following formula:
(Zr,Hf)ₐCu_{b}Ti_{c}Al_{d}Reₑ,
wherein a, b, c, d, and e are atomic percent content of elements in the amorphous alloy, and fulfill 58 ≤ a ≤ 65, 22 ≤ b ≤ 35, 0.1 ≤ c ≤ 4, 7 ≤ d ≤ 13, and 0.05 ≤ e ≤ 2 respectively.

37. The electronic device according to claim 32 or 33, wherein the Zr-based amorphous alloy has the following formula:
(Zr,Hf)ₐCu_{b}Ti_{c}Al_{d}Reₑ,
wherein a, b, c, d, and e are atomic percent content of elements in the amorphous alloy, and fulfill 48 ≤ a ≤ 54, 36 ≤ b ≤ 42, 0.1 ≤ c ≤ 4, 7 ≤ d ≤ 13, and 0.05 ≤ e ≤ 2 respectively.

38. The electronic device according to claim 31 or 32, wherein the Zr-based amorphous alloy has the following formula:
(Zr,Nb)ₐCu_{b}Ti_{c}Al_{d}Reₑ,
wherein a, b, c, d, and e are atomic percent content of elements in the amorphous alloy, and fulfill 58 ≤ a ≤ 65, 22 ≤ b ≤ 35, 0.1 ≤ c ≤ 4, 7 ≤ d ≤ 13, and 0.05 ≤ e ≤ 2 respectively.

39. The electronic device according to claim 32 or 33, wherein the Zr-based amorphous alloy has the following formula:
(Zr,Nb)ₐCu_{b}Ti_{c}Al_{d}Reₑ,
wherein a, b, c, d, and e are atomic percent content of elements in the amorphous alloy, and fulfill 48 ≤ a ≤ 54, 36 ≤ b ≤ 42, 0.1 ≤ c ≤ 4, 7 ≤ d ≤ 13, and 0.05 ≤ e ≤ 2 respectively.

40. The electronic device according to claim 32 or 33, wherein in the Zr-based amorphous alloy, a part of Cu is replaced with Ni, that is, the Zr-based amorphous alloy has the following formula:
Zrₐ(Cu,Ni)_{b}Ti_{c}Al_{d}Reₑ,
wherein a, b, c, d, and e are atomic percent content of elements in the amorphous alloy, and fulfill 46 ≤ a ≤ 50, 36 ≤ b ≤ 42, 0.1 ≤ c ≤ 5, 7 ≤ d ≤ 13, and 0.05 ≤ e ≤ 2 respectively.

41. The electronic device according to claim 32 or 33, wherein in the Zr-based amorphous alloy, a part of Cu is replaced with Ni, that is, the Zr-based amorphous alloy has the following formula:
Zrₐ(Cu,Ni)_{b}Ti_{c}Al_{d}Reₑ,
wherein a, b, c, d, and e are atomic percent content of elements in the amorphous alloy, and fulfill 54 ≤ a ≤ 63, 22 ≤ b ≤ 35, 0.1 ≤ c ≤ 5, 7 ≤ d ≤ 13, and 0.05 ≤ e ≤ 2 respectively.
